Europäisches Patentamt

European Patent Office

Office européen des brevets

(11) Numéro de publication: **0 345 118**
**A1**

# DEMANDE DE BREVET EUROPEEN

(21) Numéro de dépôt: **89401401.8**

(22) Date de dépôt: **23.05.89**

(51) Int. Cl.⁴: **G 01 R 33/24**

(30) Priorité: **31.05.88 FR 8807214**

(43) Date de publication de la demande:
**06.12.89 Bulletin 89/49**

(84) Etats contractants désignés: **DE ES GB IT**

(71) Demandeur: **THOMSON-CSF**
**51, Esplanade du Général de Gaulle**
**F-92800 Puteaux (FR)**

(72) Inventeur: **Penven, Paul**
**THOMSON-CSF SCPI Cédex 67**
**F-92045 Paris la Défense (FR)**

**Jerome, Denis**
**THOMSON-CSF SCPI Cédex 67**
**F-92045 Paris la Défense (FR)**

**Michel, Philippe**
**THOMSON-CSF SCPI Cédex 67**
**F-92045 Paris la Défense (FR)**

**Moradpour, Alexandre**
**THOMSON-CSF SCPI Cédex 67**
**F-92045 Paris la Défense (FR)**

(74) Mandataire: **Guérin, Michel et al**
**THOMSON-CSF SCPI**
**F-92045 PARIS LA DEFENSE CEDEX 67 (FR)**

(54) Matériau organique à très fable largeur de raie RPE, et sonde de gaussmètre ou de magnétomètre utilisant ce matériau.

(57) L'invention se rapporte à un matériau organique à très faible largeur de raie de résonance paramagnétique électronique (RPE). Ce matériau est constitué par un sel de tétrahydro 1, 2, 7, 8 cyclopentapérylène qui peut, avantageusement, avoir subi un traitement thermique.

Applications à la fabrication de sondes pour gaussmètres et magnétomètres.

EP 0 345 118 A1

## Description

### MATERIAU ORGANIQUE TRES FAIBLE LARGEUR DE RAIE RPE ET SONDE DE GAUSSMETRE OU DE MAGNETOMETRE UTILISANT CE MATERIAU

La présente invention concerne un matériau organique à très faible largeur de raie de résonance paramagnétique électronique (RPE) et son application dans l'élaboration de gaussmètres ou de magnétomètres.

Pour pouvoir réaliser notamment des détecteurs d'anomalies magnétiques fonctionnant en champ terrestre, différents centres de recherches se sont mis à étudier certains matériaux organiques présentant des largeurs de raie RPE très faibles. Les largeurs de raie RPE désirées sont inférieures à 20 mG.

Les sels de cations radicaux dérivés de certains hydrocarbures polyaromatiques condensés, tels le fluoranthène (FA) et le pérylène (PY) ont des propriétés de résonance paramagnétique électronique (RPE) remarquables. Pour $(FA)_2$ $PF_6$, par exemple, un signal RPE remarquablement étroit à la température ambiante a été observé.

Ce matériau possède une largeur pic-à-pic de la dérivée en champ du signal d'absorption qui n'est que de 10 milligauss. Ce signal est donc pratiquement 100 fois plus étroit que le signal RPE du radical diphénylpicrylhydrazyle (DPPH) utilisé habituellement comme marqueur de champ en RPE. Cependant, si l'absence d'hétéroatomes dans ces matériaux peut être favorable à l'étroitesse des largeurs de raies RPE, elle est en revanche un facteur qui entraîne une certaine instabilité thermique. Ainsi, par exemple, les sels préparés à partir du naphtalène ne sont stables qu'au-dessous de -40°C, alors que la largeur de la raie RPE correspondante est la plus étroite (4 milligauss) de toute cette série de matériaux.

L'étroitesse remarquable de ces raies de résonance paramagnétique électronique devrait permettre l'utilisation de ces matériaux pour la réalisation de magnétomètres de très haute sensibilité à condition que leur stabilité thermique dans le temps, largement insuffisante actuellement, soit notablement améliorée.

Concernant les pérylènes substitués, un petit nombre seulement d'alkylpérylènes ont été synthétisés. Il s'agit des trois monométhyl régioisomères, du 1- (n butyl) - pérylène, du 1- et du 2- éthylpérylène, des 2,8-, 3,9- et 2,11-diméthylpérylènes. Les alkylpérylènes avec des niveaux de substitutions plus élevés sont rares et seul le tétrahydro-1, 2, 7, 8 cyclopenta [cd ; 1m] pérylène a été synthétisé avec un faible rendement (N. TANAKA, T. KASAI, Bulletin of the Chemical Society of Japan, 1981, vol. 54, p. 3026).

L'article "Radical-cation salts of substituted perylenes" de R. LAPOUYADE, J.P. MORAND, D. CHASSEAU, C. HAUW et P. DELHAES paru dans le JOURNAL DE PHYSIQUE (Colloque C3, supplément au n° 6, tome 44, juin 1983, pages C3-1235 à C3-1238) concerne un sel de cation radical du tétrahydro-1, 2, 7, 8 cyclopenta [cd ; 1m] pérylène.

Ce pérylène substitué peut être plus simplement désigné sous le terme CPP. La stoechiométrie du sel en question est $(CPP)_2^+$ $PF_6^-$, $CH_2Cl_2$.

D'après les auteurs de cet article, ce sel posséderait une largeur pic-à-pic de la dérivée en champ du signal d'absorption qui serait de l'ordre de 80 milligauss.

Afin d'obtenir un matériau possédant une bonne stabilité thermique à température ambiante tout en possédant à la fois une largeur de raie RPE inférieure à 20 mG et une bonne stabilité à l'air, la demanderesse a effectué de nombreux travaux sur différents sels de matériaux organiques et en particulier sur des pérylènes substitués. Elle a repris et approfondi des études, entre autres, sur le tétrahydro-1, 2, 7, 8 cyclopenta [cd ; 1m] pérylène ou CPP. Les conclusions de ces études se sont révélées étonnantes. En effet, le sel de CPP suivant : $(CPP)_2^+$ $PF_6^-$, $CH_2$ $Cl_2$ qui avait été annoncé dans l'article "Radical-cation salts of substituted perylenes" de R. LAPOUYADE, J.P. MORAND, D. CHASSEAU, C. HAUW et P. DELHAES paru dans le JOURNAL DE PHYSIQUE (Colloque C3, supplément au n° 6, tome 44, juin 1983, pages C3-1235 à C3-1238) comme ayant une largeur de raie RPE de 80 mG s'est révélé en fait avoir une largeur de raie RPE de 16mG.

Du fait de la largeur de raie annoncée (80 mG) et qui n'avait été définie que pour la caractérisation du matériau, il n'était pas pensable de s'en servir pour réaliser des sondes de champ magnétique pour gaussmètres ou magnétomètres.

La demanderesse a poursuivi ses travaux sur le matériau en question et a trouvé qu'un traitement thermique approprié avait, contre toute attente, des conséquences très bénéfiques sur la largeur de raie RPE et donc sur les possibilités d'exploitation de ce matériau.

L'invention a donc pour objet un matériau organique à très faible largeur de raie de résonance paramagnétique électronique utilisable dans des sondes de gaussmètre ou de magnétomètre, caractérisé en ce qu'il est constitué par un sel de tétrahydro-1, 2, 7, 8 cyclopentapérylène.

L'invention a aussi pour objet une sonde de gaussmètre ou de magnétomètre, caractérisée en ce qu'elle utilise le matériau organique ci-dessus.

L'invention sera mieux comprise et d'autres avantages apparaîtront grâce à la description qui va suivre, donnée à titre non limitatif, accompagnée des dessins annexés parmi lesquels :

    - la figure 1 représente, de façon schématique, un premier dispositif de mesure de la largeur de raie RPE,

    - la figure 2 représente, de façon schématique, un deuxième dispositif de mesure de la largeur de raie RPE.

Des mesures effectuées par la demanderesse sur le tétrahydro-1, 2, 7, 8 cyclopentapérylène ou CPP, sous forme de sel [$(CPP)_2^+PF_6^-$, $CH_2Cl_2$], ont montré que la largeur de raie RPE est de 16 milligauss. En outre, lorsque ce sel subit un traitement thermique approprié (par exemple lorsqu'on le porte à 60°C pendant environ 2 heures), la largeur de raie RPE est de 13 milligauss après retour à la température ambiante. Le matériau obtenu est stable à l'air et leur raie RPE ne se dégrade pas dans le temps jusqu'à une température de 80°C.

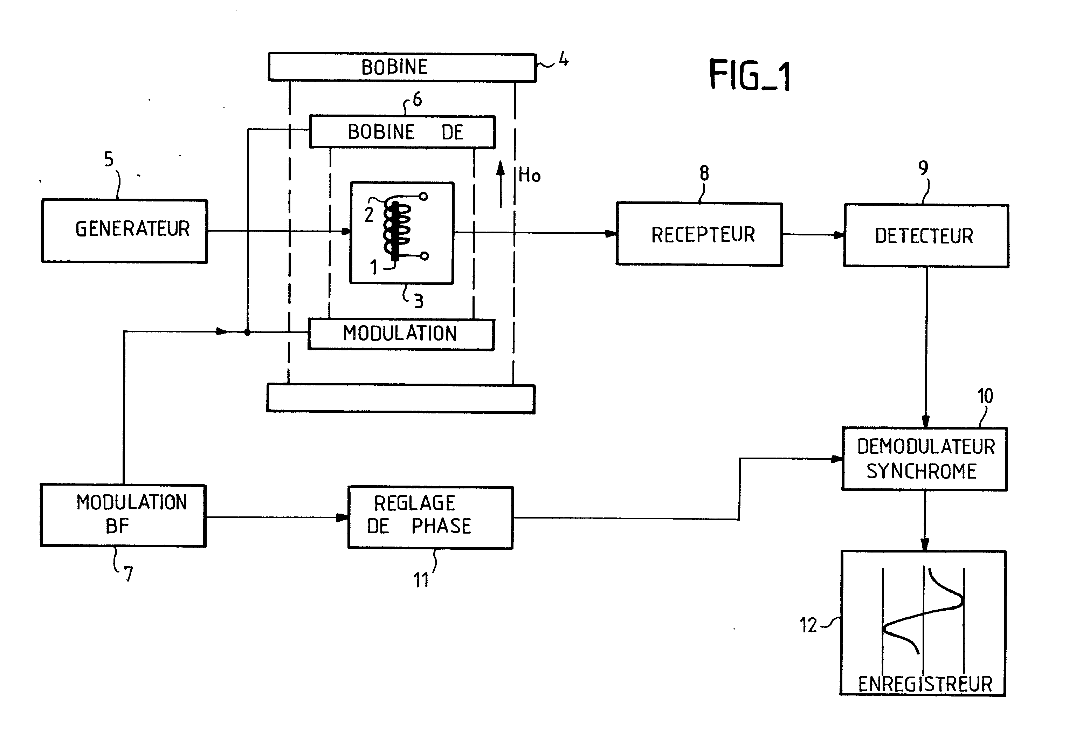

La figure 1 représente, de façon schématique, le dispositif expérimental de mesure de la largeur de raie RPE d'un matériau du type de celui de l'invention.

L'échantillon 1, dont on veut mesurer la largeur de raie RPE, est placé à l'intérieur de la bobine 2 d'un circuit 3 comprenant, outre cette bobine, un condensateur C. Le passage à la résonance à la pulsation $\omega_o$ du circuit 3, obtenu en balayant le champ magnétique $H_o$ de la bobine 4, se traduit par une charge supplémentaire du générateur 5 ou une modification du facteur de qualité de son circuit résonnant. On montre alors que la puissance dissipée est proportionnelle au produit :

$$\omega_o \times H_o^2 \times \tau'' \times V \quad (1)$$

où $\tau''$ est la partie imaginaire de la susceptibilité magnétique du matériau analysé et V le volume de l'échantillon.

Pour plus de détails, on se référera utilement à l'ouvrage "Les principes du magnétisme nucléaire" par A. ABRAGAM (Bibliothèque des Sciences et Techniques Nucléaires, P.U.F., 1961, p. 86).

L'utilisation d'une modulation de champ magnétique (par l'intermédiaire de la bobine 6) ou de fréquence et d'un détecteur synchrone permet d'améliorer la sensibilité du dispositif de mesure. Selon le schéma de la figure 1, le dispositif comprend encore un appareil de modulation BF 7 agissant sur la bobine de modulation 6. Le signal de sortie du circuit 3 est reçu par le récepteur 8 qui délivre un signal au détecteur 9. Le signal de sortie du détecteur 9 est reçu par le démodulateur synchrone 10 qui, en fonction d'un signal de réglage de phase issu d'un dispositif 11 de réglage de phase du signal de référence, délivre à l'enregistreur 12 un signal permettant de visualiser la dérivée en champ du signal d'absorption.

On peut utiliser les différents dispositifs expérimentaux proposés par A. ABRAGAM dans l'ouvrage cité plus haut : méthode du Q-mètre, méthode du pont, méthode des bobines croisées, oscillateur marginal, méthodes transitoires de détection, etc...

Dans les conditions expérimentales suivantes :
- champ magnétique $H_o$ = 8 gauss
- bande passante 0,3 Hz
- masse de l'échantillon 4 mg
le rapport signal/bruit obtenu est de 100.

Pour une raie de 13 milligauss de largeur, la précision de la mesure du champ de résonance est de 0,13 milligauss environ.

A titre d'exemple, on peut ainsi mesurer rapidement (en 3 secondes) et avec une précision voisine de 0,1 milligauss, en utilisant la relation (1) :
- un champ magnétique de 8 gauss avec 4 mg de sel de CPP ayant subi un traitement thermique, ce qui représente le volume d'un cylindre de 1 mm de diamètre et de 5 mm de longueur,
- un champ magnétique de 80 gauss avec 0,04 mg du même sel de CPP, ce qui représente un monocristal de matériau,
- un champ magnétique de 0,8 gauss avec 400 mg du même sel de CPP, ce qui représente le volume d'un cylindre de 7 mm de diamètre et de 1 cm de longueur.

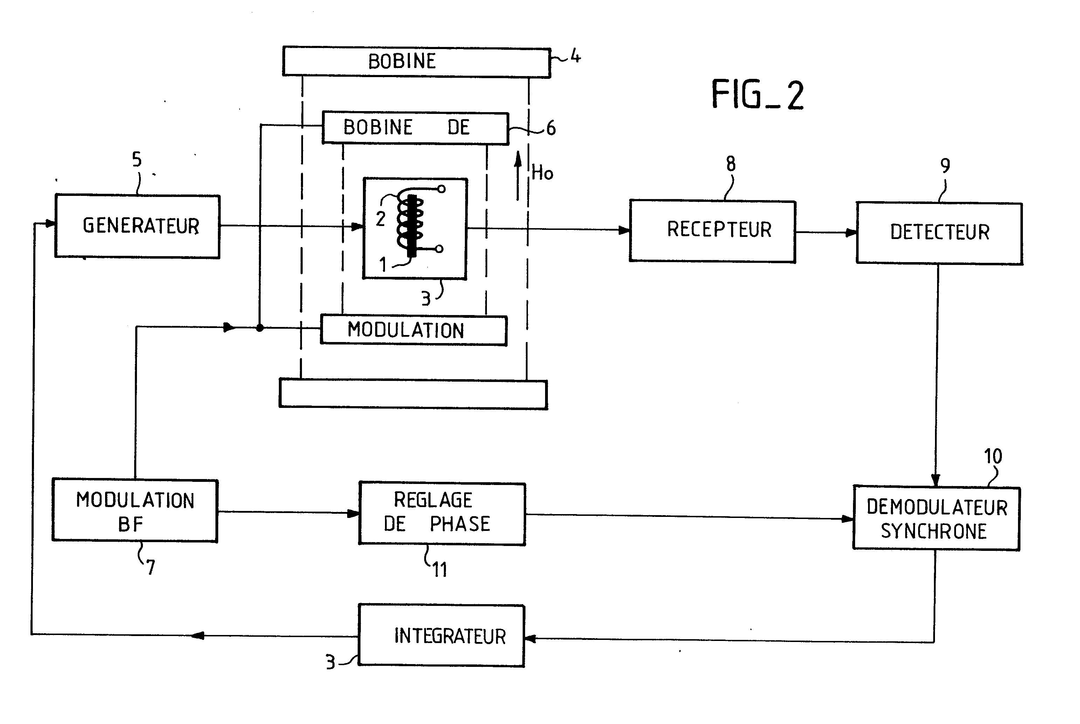

On peut mesurer les variations de champ magnétique en utilisant le signal RPE pour asservir la fréquence de sorte qu'à tout instant, la condition de résonance soit réalisée. La mesure de la variation de fréquence fournit directement la variation de champ magnétique. Le dispositif représenté schématiquement à la figure 2 a permis d'obtenir les ordres de grandeur calculés pour 8 gauss et 0,8 gauss. Sur la figure 2, les mêmes éléments que sur la figure 1 portent les mêmes références. Un intégrateur 13 a été rajouté, qui reçoit le signal de sortie du démodulateur synchrone 10 et qui, en fonction de ce signal, va piloter la fréquence du générateur 5.

Avec le dispositif de la figure 2, on peut établir une carte de champ magnétique créé par une bobine travaillant à 50 gauss et au-delà en utilisant une sonde constituée d'un ou de quelques monocristaux du sel de CPP.

D'autres matériaux que les sels de CPP peuvent être utilisés pour réaliser des sondes de champ magnétique pour gaussmètre. Cependant, leur nombre est très restreint, car ils doivent présenter des largeurs de raie RPE très faibles (inférieures à 20 milligauss) pour permettre une mesure suffisamment rapide, précise avec une sonde de dimensions réduites. En effet, la sensibilité du gaussmètre est proportionnelle à la pente de la raie RPE au voisinage du champ magnétique de résonance. Elle est donc proportionnelle à l'amplitude pic-à-pic de la raie RPE et inversement proportionnelle à la largeur de raie. Or, pour des matériaux de susceptibilité $\tau''$ du même ordre de grandeur, ce qui est le cas des sels de radicaux cations, l'amplitude pic-à-pic du signal RPE est inversement proportionnelle au carré de la largeur de raie. Par conséquent, la sensibilité du gaussmètre est inversement proportionnelle au cube de la largeur de raie RPE du matériau.

A titre d'exemple, une largeur de raie de 80 milligauss entraîne une perte de sensibilité d'un facteur 200 environ par rapport à un matériau de largeur de raie 13 milligauss. Cette perte de sensibilité ne peut se compenser, si on ne veut pas dégrader la précision de la mesure ni augmenter le temps nécessaire à la mesure, que par une augmentation considérable de la quantité d'échantillon, donc de la taille de la sonde rendant impossibles les applications décrites ci-dessus.

Selon l'art connu, les sels de radicaux cations de fluoranthène ont été proposés pour réaliser des sondes de champ magnétique pour gaussmètres, par exemple dans l'article "Gaussmeter Application of an Organic Conductor", E. DORMANN, G. SACHS, W. STOCKLEIN, B. BAIL, M. SCHWOERER, Applied Physics A vol. 30, p. 227-231, 1983. Cependant, l'instabilité thermique de la raie RPE à température ambiante et plus encore à température plus élevée empêche toute utilisation industrielle de ce gaussmètre. Aucun autre matériau stable thermiquement ne possède de raie inférieure à 15 milligauss permettant son utilisation comme sonde de champ magnétique.

Selon l'invention, l'utilisation du tétrahydro-1, 2, 7, 8 cyclopentapérylène stable jusqu'à 80°C, en remplacement des sels de fluoranthène comme sonde de champ magnétique pour gaussmètre, permet grâce à sa faible largeur de raie RPE des performances de gaussmètre comparables et grâce à sa stabilité thermique une utilisation industrielle de ce type d'appareil.

Selon l'invention d'autres sels que l'hexafluorophosphate de CPP peuvent être utilisés, par exemple l'hexafluoroarséniate. Leurs préparations ne posent pas de problèmes particuliers à l'homme de l'art.

Le traitement thermique imposé au matériau selon l'invention a pour conséquence de diminuer la largeur de raie RPE. Ceci était totalement imprévisible à l'homme de l'art parce que, dans tous les cas, les matériaux organiques utilisés dans les sondes de gaussmètres voient leurs propriétés se dégrader lorsque la température augmente et après retour à la température ambiante. Le matériau selon l'invention est le seul cas connu, dans le domaine considéré, où l'élévation de température a des conséquences bénéfiques sur les propriétés RPE.

Il faut remarquer en outre que ce traitement thermique est très facile à mettre en oeuvre. Dans l'exemple cité plus haut, c'est en portant le sel de CPP à 60° C pendant 2 heures qu'on a obtenu un produit aux propriétés RPE exceptionnelles. La température du traitement thermique et sa durée peuvent être modifiées dans certaines proportions, les valeurs indiquées ci-dessus étant des valeurs moyennes.

## Revendications

1 - Matériau organique à très faible largeur de raie de résonance paramagnétique électronique utilisable dans des sondes de gaussmètre ou de magnétomètre, caractérisé en ce qu'il est constitué par un sel de tétrahydro 1, 2, 7, 8 cyclopentapérylène.

2 - Matériau organique selon la revendication 1, caractérisé en ce que ledit sel est un hexafluorophosphate.

3 - Matériau organique selon la revendication 1, caractérisé en ce que ledit sel est un hexafluoroarséniate.

4 - Matériau organique selon l'une quelconque des revendications 1 à 3, caractérisé en ce que ledit sel a subi un traitement thermique qui a pour conséquence de diminuer sa largeur de raie de résonance paramagnétique électronique.

5 - Matériau organique selon la revendication 4, caractérisé en ce que le traitement thermique consiste à porter ledit sel à une température de 60° C pendant 2 heures.

6 - Sonde de gaussmètre ou de magnétomètre, caractérisée en ce qu'elle utilise un matériau organique selon l'une quelconque des revendications 1 à 5.

FIG_1

EP 0 345 118 A1

FIG_2

BOBINE ~4

BOBINE DE ~6

GENERATEUR

Ho

RECEPTEUR

DETECTEUR

MODULATION

MODULATION BF

REGLAGE DE PHASE

DEMODULATEUR SYNCHRONE

INTEGRATEUR

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,D | APPLIED PHYSICS A, vol. 30, avril 1983, pages 227-231, Springer-Verlag; E. DORMANN et al.: "Gaussmeter application of an organic conductor" <br> * En entier * <br> --- | 1-3,6 | G 01 R 33/24 |
| A | SOLID STATE COMMUNICATIONS, vol. 61, no. 8, 1987, pages 499-502, Pergamon Journals Ltd, GB; O. DOBBERT et al.: "Pulsed ESR investigation of spin transport proporties in the organic conductor (perylenyl)2 (AsF6)0.75(PF6)0.35.0.85CH2Cl2" <br> * Chapitre 1: "Introduction"; chapitre 3: "Results and discussion" * <br> --- | 1-5 | |
| A,D | JOURNAL DE PHYSIQUE, colloque C3, supplément no. 6, vol. 44, juin 1983, pages 1235-1238; R. LAPOUYADE et al.: "Radical-cation salts of substituted perylenes" <br> * Chapitre: "Physical properties" * <br> ----- | 1,3 | |

DOMAINES TECHNIQUES RECHERCHES (Int. Cl.4)

G 01 R 33/00

Le présent rapport a été établi pour toutes les revendications

| Lieu de la recherche | Date d'achèvement de la recherche | Examinateur |
|---|---|---|
| LA HAYE | 11-09-1989 | DIOT P.M.L. |

EPO FORM 1503 03.82 (P0402)